(19) Europäisches Patentamt
European Patent Office
Office européen des brevets

(11) **EP 3 371 884 B1**

(12) **FASCICULE DE BREVET EUROPEEN**

(45) Date de publication et mention de la délivrance du brevet:
**28.08.2024 Bulletin 2024/35**

(21) Numéro de dépôt: **16790381.4**

(22) Date de dépôt: **03.11.2016**

(51) Classification Internationale des Brevets (IPC):
**H03F 1/02** *(2006.01)* **H03F 1/32** *(2006.01)*
**H03F 3/21** *(2006.01)*

(52) Classification Coopérative des Brevets (CPC):
**H03F 1/56; H03F 1/0211; H03F 1/0277; H03F 1/3241; H03F 3/19; H03F 3/211; H03F 3/245;** H03F 2203/21106; H03F 2203/21142

(86) Numéro de dépôt international:
**PCT/EP2016/076552**

(87) Numéro de publication internationale:
**WO 2017/076969 (11.05.2017 Gazette 2017/19)**

(54) **PROCÉDÉ DE FABRICATION D'UN ÉTAGE D'AMPLIFICATION D'UN SIGNAL À ENVELOPPE VARIABLE ET ÉTAGE D'AMPLIFICATION DE PUISSANCE**

VERFAHREN ZUR HERSTELLUNG EINER VERSTÄRKUNGSSTUFE FÜR VARIABLES HÜLLKURVENSIGNAL UND VERSTÄRKUNGSSTUFE

METHOD FOR PRODUCING AN AMPLIFICATION STAGE FOR A VARIABLE ENVELOPE SIGNAL AND AMPLIFICATION STAGE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **04.11.2015 FR 1560585**

(43) Date de publication de la demande:
**12.09.2018 Bulletin 2018/37**

(73) Titulaire: **Centre National d'Etudes Spatiales (CNES)**
**75001 Paris (FR)**

(72) Inventeurs:
• **SOUBERCAZE-PUN, Geoffroy**
**31520 Ramonville-Saint-Agne (FR)**
• **LAPIERRE, Luc**
**31500 Toulouse (FR)**

(74) Mandataire: **Germain Maureau**
**12, rue Boileau**
**69006 Lyon (FR)**

(56) Documents cités:
**EP-A1- 2 840 709** **US-A- 6 141 541**
**US-A1- 2012 105 150** **US-A1- 2015 236 729**

**Description**

L'invention concerne un procédé de fabrication d'un étage d'amplification de puissance d'un signal d'entrée à enveloppe variable présentant une distribution statistique de puissance instantanée prédéterminée, cet étage d'amplification délivrant une puissance moyenne de sortie POUT prédéterminée et comprenant au moins un amplificateur et des circuits d'adaptation déterminant des paramètres de réglage (par exemple choisis pour des circuits à état solide parmi des tensions de polarisation, la valeur complexe de l'impédance de charge,... ; ou pour des tubes à ondes progressives parmi le courant de faisceau, la tension d'hélice, les tensions de collecteurs,...) dont la valeur influence des fonctions de transfert en puissance moyenne POUT(PIN), en phase PM(PIN), et en consommation PDC(PIN), de l'étage d'amplification. Elle s'étend à un étage d'amplification ainsi fabriqué.

Le problème des défauts de linéarité des amplificateurs de puissance se pose depuis très longtemps (plusieurs dizaines d'années), plus particulièrement dans le domaine des hyperfréquences (300 MHz à 300 GHz), par exemple pour les télécommunications et/ou la télédiffusion (satellitaire ou terrestre) et/ou les liaisons bord/sol avec les satellites artificiels en orbite autour de la Terre. En effet, dans ces applications comme dans d'autres, l'optimisation du bilan de puissance et de l'efficacité spectrale conduit à utiliser des amplificateurs à haute puissance (HPA) dans toute leur gamme de fonctionnement, c'est-à-dire jusqu'à la zone de saturation.

Plusieurs méthodes de linéarisation sont connues jusqu'à maintenant pour remédier à ce problème, notamment des méthodes dites de post-distorsion, des méthodes dites d'égalisation avec un circuit modélisé faisant suite à l'étage d'amplification imparfait, et des méthodes de pré-distorsion consistant :

- soit à modéliser le circuit imparfait, notamment par un modèle analytique pouvant être inversé (par exemple polynomial avec ou sans mémoire, séries de Volterra,...) ou numérique (tables de coefficients modélisant les fonctions de transfert, réseaux de neurones...), ou spécifique (Hammerstein, Wienner, Hammerstein-Wienner, Wienner parallèle...), et à introduire en entrée du circuit imparfait un circuit de pré-distorsion produisant une réponse conforme à ce modèle inversé ;
- soit à ajouter en série un circuit de pré-distorsion paramétrable dont les caractéristiques de transfert (notamment en puissance moyenne et en phase) sont ajustées empiriquement par itérations successives en observant les variations du signal de sortie en fonction de celles du signal d'entrée.

Les premières méthodes de linéarisation ne sont pas toujours utilisables, par exemple lorsqu'il n'existe pas de fonction inverse du modèle s'appliquant au circuit non linéaire. De surcroît, dans le cas des amplificateurs, la fonction inverse de la modélisation de la caractéristique en puissance du HPA présente, par principe, une singularité au voisinage de la saturation, puisque sa pente tend vers l'infini. En outre, elles sont le plus souvent extrêmement complexes et difficiles à mettre en oeuvre et/ou dédiées à des catégories spécifiques de circuits non linéaires ou à des applications très spécifiques et/ou peu précises par nature (c'est-à-dire ne produisant pas des résultats de qualité suffisante compte tenu des approximations apportées par la modélisation). Elles nécessitent des ressources informatiques et énergétiques extrêmement lourdes, non nécessairement disponibles (par exemple à bord d'un système spatial). En outre, certaines modèles sont applicables uniquement aux amplificateurs à tube à onde progressive, mais non aux circuits à état solide.

Les deuxièmes méthodes de linéarisation induisent des coûts d'optimisation extrêmement importants et sont également imparfaites dans la mesure où il n'est pas certain à l'avance de pouvoir trouver par itérations successives un ajustement des différentes caractéristiques du circuit de pré-distorsion paramétrable permettant effectivement d'obtenir empiriquement une réponse appropriée en sortie du circuit non linéaire.

Par ailleurs, de nombreuses propositions ont été faites en vue d'optimiser certaines de ces méthodes de linéarisation, par exemple pour permettre une adaptation ou une optimisation dynamique en temps réel des caractéristiques de la pré-distorsion, notamment avec une boucle de rétroaction. Mais, là encore, ces optimisations ne sont applicables que dans des contextes de circuits et/ou d'applications très spécifiques, et leur mise en oeuvre est complexe en pratique.

Ainsi, US 2012/0105150 décrit une méthode de commande d'un système d'amplification dans lequel les tensions de polarisation et d'alimentation sont modulées instantanément en fonction de signaux dérivés de la tension d'enveloppe du signal d'entrée. Ce circuit nécessite un détecteur d'enveloppe, et un étage de sélection de tension qui génère la tension d'alimentation et la tension de polarisation à appliquer à l'étage d'amplification. Des éléments de cartographie non linéaire permettent de définir les valeurs de la tension d'alimentation et de la tension de polarisation en fonction de l'enveloppe du signal d'entrée, par exemple selon une expansion polynomiale d'ordre 3 et/ou par des tables de valeurs établies par caractérisation du dispositif.

US 2015/0236729 décrit également un procédé et un appareil permettant d'optimiser dynamiquement en temps réel un étage d'amplification par détection d'enveloppe du signal d'entrée. Là encore, ce circuit intègre nécessairement un système de détection d'enveloppe (« envelope tracking » (ET)).

En conséquence, les méthodes de linéarisation connues sont lourdes, coûteuses, non universelles, limitées à des circuits ou des applications particulières, toujours imparfaites par principe et le plus souvent insuffisamment précises. Ainsi, malgré le fait que ce problème de linéarisation se pose depuis très longtemps, aucune solution satisfaisante simple, économique, universelle et parfaitement efficace par conception n'a été apportée jusqu'à ce jour.

Indépendamment des méthodes de linéarisation, le problème qui se pose donc pour la fabrication d'un étage d'amplification de puissance d'un signal à enveloppe variable, tel qu'un signal de communication hyperfréquence, consiste à optimiser les réglages des circuits d'adaptation pour obtenir des réponses aussi linéaires que possible avec simultanément des valeurs optimales de critères d'optimisation tels que la puissance moyenne de sortie et/ou le rendement et/ou la consommation et/ou la puissance dissipée. Ces contraintes sont en effet antagonistes : une bonne linéarité ne peut être garantie qu'en contrepartie d'une faible valeur de la puissance de sortie afin de rester en deçà de la saturation, et une exploitation optimale du circuit jusqu'à la saturation nuit à la linéarité du signal amplifié. Il en résulte la nécessité de multiplier les composants nécessaires à l'obtention d'une puissance de sortie suffisante, au prix d'une augmentation de la masse et/ou de l'encombrement et/ou du coût des équipements.

Par exemple, dans le cas d'amplificateurs formés de transistors (circuits électroniques à état solide) cette optimisation consiste à déterminer les caractéristiques de l'impédance de charge et de la polarisation de chaque transistor, chacun de ces deux paramètres possédant en général deux variables (tension de grille et tension de drain pour un transistor à effet de champ FET ; parties réelle et imaginaire de l'impédance de charge). La publication « Optimization criteria for power amplifiers », J. Sombrin, International Journal of Microwave and Wireless Technologies, Vol. 3, Issue 1, pp. 35-45, 2011, mentionne ainsi différents critères qui peuvent être théoriquement avantageusement utilisés pour l'optimisation d'amplificateurs de puissance.

Différentes solutions plus ou moins complexes ont été développées par le passé pour déterminer les réglages des circuits d'adaptation. Dans le cas de transistors, une technique traditionnelle consiste à choisir des valeurs de polarisation, et à explorer, grâce à un banc de test (désigné en anglais « load pull »), l'ensemble des impédances de l'abaque de Smith en extrayant les caractéristiques en puissance moyenne, phase et consommation en utilisant un signal sinusoïdal à enveloppe constante à la fréquence souhaitée afin de trouver le rendement électrique maximal à la puissance de saturation. La performance pouvant être atteinte en termes de puissance et rendement, pour un rapport signal utile sur intermodulation donné selon l'application (c'est à dire en fonction de la forme d'onde) est ensuite déduite à partir des caractéristiques du signal d'entrée réel à enveloppe variable. Les défauts de linéarité en amplitude, en phase et en consommation sont alors subis.

L'invention, qui est décrite par le contenu des revendications indépendantes, vise à pallier ces inconvénients en proposant un procédé permettant de mieux optimiser les paramètres de réglage d'un étage d'amplification, et ce de façon plus rapide, plus simple et plus systématique, qui soit applicable avec diverses technologies d'amplificateurs et divers signaux d'entrée, notamment des signaux de communication, plus particulièrement dans le domaine des hyperfréquences (300 MHz à 300 GHz).

L'invention vise également à proposer un tel procédé qui puisse être mis en oeuvre de façon simple, avec les installations et dispositifs traditionnels, et qui ne modifie pas les habitudes de travail.

Dans tout le texte, on désigne par « signal à enveloppe variable » tout signal présentant une amplitude variable dans le temps à une fréquence prédéterminée correspondant à la fréquence minimale du signal.

L'invention concerne donc un procédé de fabrication d'un étage d'amplification de puissance d'un signal d'entrée à enveloppe variable présentant une distribution statistique de puissance instantanée prédéterminée, cet étage d'amplification comprenant au moins un amplificateur et des circuits d'adaptation déterminant des paramètres de réglage dont la valeur influence des fonctions de transfert en puissance moyenne POUT(PIN), en phase PM(PIN), et en consommation PDC(PIN), de l'étage d'amplification,

caractérisé en ce qu'il comprend les étapes suivantes :

- pour chaque amplificateur, sélection d'une forme de variation idéale en puissance moyenne $POUT_L(PIN)$ dérivable en tout point et pouvant être procurée par un choix approprié des circuits d'adaptation,
- pour chaque amplificateur, calcul, pour chaque valeur de chaque paramètre de réglage et pour chaque valeur PIN de puissance moyenne d'entrée, d'une valeur d'un critère d'optimisation en fonction de l'espérance mathématique, avec la distribution statistique du signal d'entrée, d'au moins un paramètre d'optimisation lié à la puissance moyenne de sortie de l'amplificateur, cette espérance mathématique étant calculée avec ladite distribution statistique de puissance instantanée du signal d'entrée,
- pour chaque amplificateur, sélection à partir de chaque valeur du critère d'optimisation, d'une valeur optimale de chaque paramètre de réglage représentant une optimisation du critère d'optimisation de l'amplificateur, et détermination d'une valeur de puissance moyenne de sortie correspondante de l'amplificateur,
- fabrication de l'étage d'amplification avec un nombre N d'amplificateur(s) en parallèle déterminé en fonction d'une valeur de puissance moyenne de sortie à fournir par l'étage d'amplification, et avec, pour chaque amplificateur, des circuits d'adaptation procurant lesdites valeurs optimales des paramètres de réglage.

Ainsi, l'utilisation de la distribution statistique de puissance instantanée du signal d'entrée à enveloppe variable dans un procédé selon l'invention permet de calculer la valeur d'un critère d'optimisation et de choisir des paramètres de réglage représentant une optimisation de ce critère d'optimisation, tout en conservant une liberté de sélection d'une forme de variation idéale en puissance moyenne, sélection qui peut, elle, être effectuée notamment selon au moins un critère de performance de l'étage d'amplification, par exemple une valeur prédéterminée du rapport signal/bruit et/ou du taux d'intermodulation.

L'invention se fonde ainsi sur une approche totalement différente de celle de l'état de la technique, en utilisant la distribution statistique de puissance instantanée prédéterminée du signal d'entrée enveloppe variable pour fabriquer les circuits d'adaptation directement optimisés à cette distribution. Les circuits d'adaptation étant fabriqués de façon à procurer lesdites valeurs optimales des paramètres de réglage, l'étage d'amplification ainsi fabriqué selon l'invention ne nécessite ni détecteur d'enveloppe du signal d'entrée, ni circuit permettant l'ajustement dynamique en temps réel de tensions d'alimentation ou de polarisation.

En particulier, dans certains modes de réalisation conformes à l'invention, le critère d'optimisation est choisi parmi la puissance moyenne de sortie POUTk de l'amplificateur (k étant dans tout le texte un indice associé, lorsque nécessaire, à chaque amplificateur k de l'étage d'amplification) ; la consommation PDCk de l'amplificateur ; la puissance dissipée DISSk par l'amplificateur ; et un rendement de l'amplificateur déterminé par le rapport entre la puissance moyenne de sortie POUTk et la consommation PDCk ; et leurs combinaisons. La valeur optimale de chaque paramètre de réglage est alors choisie de façon à maximiser la puissance moyenne de sortie POUTk, ou minimiser la consommation PDCk, ou minimiser la puissance dissipée DISSk ou maximiser le rendement.

En outre, selon l'invention, au moins un paramètre d'optimisation est choisi parmi la puissance moyenne de sortie POUTk de l'amplificateur et la consommation PDCk de l'amplificateur, chaque valeur du critère d'optimisation étant calculée en fonction de l'espérance mathématique, avec la distribution statistique du signal d'entrée, de ce paramètre d'optimisation à partir au moins de ladite variation idéale en puissance moyenne $POUT_L(PIN)$. Si on choisit la puissance moyenne de sortie POUTk à titre de critère d'optimisation, on peut utiliser uniquement cette puissance moyenne de sortie à titre de paramètre d'optimisation, et calculer uniquement l'espérance mathématique de la puissance moyenne de sortie selon la variation idéale en puissance moyenne $POUT_L(PIN)$ avec la distribution statistique du signal d'entrée. Si on choisit la consommation PDCk à titre de critère d'optimisation, on peut utiliser uniquement la consommation à titre de paramètre d'optimisation, et calculer uniquement l'espérance mathématique de la consommation PDCk dont une variation idéale $PDC_L(PIN)$ peut être déterminée à partir de la variation idéale en puissance moyenne $POUT_L(PIN)$. Si on choisit la puissance dissipée à titre de critère d'optimisation, on utilise à la fois la puissance moyenne de sortie POUTk et la consommation PDCk à titre de paramètres d'optimisation, dont on calcule la différence des espérances mathématiques. Si on choisit le rendement à titre de critère d'optimisation, on utilise à la fois la puissance moyenne de sortie POUTk et la consommation PDCk à titre de paramètres d'optimisation, dont on calcule le rapport des espérances mathématiques.

En particulier, dans certains modes de réalisation un procédé selon l'invention est aussi caractérisé en ce qu'au moins un paramètre d'optimisation est la consommation PDCk de l'amplificateur, et en ce qu'il comprend en outre les étapes suivantes :

- caractérisation de chaque amplificateur, à l'aide d'un banc de test mesurant et enregistrant, pour chaque valeur de chaque paramètre de réglage, des variations caractéristiques, en fonction de la puissance moyenne d'entrée PIN, de la puissance moyenne POUTcw(PIN) et de la consommation PDCcw(PIN) à partir d'un signal à enveloppe constante appliqué à l'entrée du banc de test,
- pour chaque amplificateur, calcul, pour chaque valeur de chaque paramètre de réglage, d'une variation idéale de la consommation $PDC_L(PIN)$ en fonction de la puissance moyenne d'entrée PIN, à partir de ladite variation idéale en puissance moyenne $POUT_L(PIN)$ et desdites variations caractéristiques,

et en ce que chaque valeur du critère d'optimisation est déterminée en fonction de l'espérance mathématique, avec la distribution statistique du signal d'entrée, de la consommation $PDC_L(PIN)$ obtenue à partir de ladite variation idéale de la consommation $PDC_L(PIN)$ en fonction de la puissance moyenne d'entrée PIN.

En outre, dans certains modes de réalisation, l'invention comprend une étape de caractérisation de chaque amplificateur, à l'aide d'un banc de test mesurant et enregistrant, pour chaque valeur de chaque paramètre de réglage, des variations caractéristiques, en fonction de la puissance moyenne d'entrée PIN, du décalage de phase PMcw(PIN) de l'amplificateur à partir du signal d'entrée à enveloppe constante, et, les circuits d'adaptation sont choisis pour obtenir un décalage de phase de valeur prédéterminée, notamment nulle.

Par ailleurs, dans certains modes de réalisation selon l'invention, ladite forme de variation idéale en puissance moyenne $POUT_L(PIN)$ est une variation affine -notamment linéaire- jusqu'à une valeur supérieure de début de saturation. On choisit en particulier avantageusement une variation linéaire présentant une performance prédéterminée au point de saturation, par exemple un rapport signal/bruit prédéterminé, par exemple de l'ordre de 15 dB, ou un taux d'intermodulation prédéterminé ou autre. Il est à noter que cette performance prédéterminée reste toujours la même quelles que soient les valeurs des paramètres de réglage. Également, on choisit avantageusement une variation linéaire présentant une courbure en début de saturation de façon à pouvoir être dérivable en tous points, y compris au point de saturation.

D'autres formes de variation idéale en puissance moyenne de sortie peuvent être choisies. En particulier, il est possible de prévoir que cette forme de variation idéale présente une augmentation supérieure à la variation affine de la puissance immédiatement avant le début de la saturation. Il suffit à ce titre que cette forme de variation idéale soit dérivable en tout point et puisse être obtenue par des circuits électroniques appropriés. Le choix et la configuration des circuits d'adaptation permettant d'obtenir cette variation idéale en puissance moyenne de sortie et/ou en décalage de phase peuvent être effectués selon tout procédé connu par ailleurs, par exemple conformément à la demande de brevet français FR1453773.

Par ailleurs, si l'invention s'applique à tout signal d'entrée à enveloppe variable présentant une distribution statistique de puissance instantanée prédéterminée, elle s'applique plus particulièrement avantageusement à un signal d'entrée -notamment un signal de communication- comprenant une modulation selon un schéma de modulation prédéterminé, comprenant une (ou plusieurs) porteuse(s). Dans ces applications, avantageusement et selon l'invention, le signal d'entrée à enveloppe variable présente une densité de probabilité de puissance instantanée du signal d'entrée déterminée en fonction du schéma de la modulation du signal de communication. En effet, il s'avère que tout signal modulé présente une densité de probabilité de la puissance instantanée qui est caractéristique du schéma de modulation. L'invention s'applique néanmoins plus généralement à tout signal d'entrée à enveloppe variable présentant une distribution statistique de puissance instantanée permettant de déterminer une densité de probabilité de la puissance instantanée, et de calculer une espérance mathématique de la puissance moyenne pour ce signal. L'inventeur a ainsi démontré que la distribution statistique du signal d'entrée peut être utilisée pour calculer l'espérance mathématique d'un paramètre d'optimisation à partir de la variation idéale en puissance moyenne $POUT_L(PIN)$ du signal de sortie amplifié, et que, de façon inattendue, cette espérance mathématique est en fait très pertinente pour évaluer de façon simple mais très précise, un critère d'optimisation de l'amplificateur.

Par ailleurs, dans certains modes de réalisation avantageux selon l'invention, ladite forme de variation idéale en puissance moyenne $POUT_L(PIN)$ est choisie en fonction d'un critère de performance de l'étage d'amplification choisi parmi une valeur d'un rapport signal/bruit et un taux d'intermodulation. D'autres critères de performance peuvent être utilisés en variante.

L'invention s'applique également plus particulièrement, bien que non exclusivement, avantageusement à un signal d'entrée hyperfréquence, notamment à un signal d'entrée modulé comprenant une (ou plusieurs) porteuse(s) ayant une fréquence de porteuse dans une bande de fréquence pouvant être choisie dans le domaine des hyperfréquences (300 MHz à 300 GHz), ou en dehors de ce domaine.

Par ailleurs, dans certains modes de réalisation avantageux selon l'invention, au moins un amplificateur étant un transistor, lesdits paramètres de réglage sont choisis dans le groupe formé d'au moins une tension de polarisation et d'au moins une caractéristique d'impédance de charge. Dans le cas d'un amplificateur formé d'un transistor à effet de champ, les paramètres de réglage sont la tension de grille, la tension de drain, la partie réelle de l'impédance de charge et la partie imaginaire de l'impédance de charge (ou le facteur de puissance φ).

En variante ou en combinaison, avantageusement et selon l'invention, au moins un amplificateur étant un tube à ondes progressives, lesdits paramètres de réglage sont choisis dans le groupe formé d'un courant de faisceau, d'une tension d'hélice, et d'une tension de collecteur.

Par ailleurs, une fois les paramètres de réglage de chaque amplificateur déterminés selon le critère d'optimisation, l'étage d'amplification peut être fabriqué avec un (ou plusieurs) amplificateur(s) en parallèle. Dans le cas de plusieurs amplificateurs en parallèle, on utilise avantageusement une pluralité d'amplificateurs identiques. Rien n'empêche cependant au contraire d'utiliser des amplificateurs différents en tant que de besoin.

Selon l'invention, l'étage d'amplification délivrant une puissance moyenne de sortie POUT prédéterminée, pour chaque amplificateur, une valeur de puissance moyenne de sortie POUTk de l'amplificateur est déterminée pour les valeurs optimales de chaque paramètre de réglage, et le nombre N d'amplificateur(s) en parallèle de l'étage d'amplification est choisi tel que :

$$\sum_1^{N-1} POUTk \leq POUT \leq \sum_1^N POUTk$$

La puissance moyenne de sortie POUTk de chaque amplificateur est avantageusement calculée à partir de l'espérance mathématique de la puissance moyenne de sortie de chaque amplificateur calculée comme indiqué précédemment.

L'invention s'étend à un étage d'amplification obtenu par un procédé de fabrication selon l'invention. Elle concerne donc également un étage d'amplification de puissance d'un signal d'entrée à enveloppe variable présentant une distribution statistique de puissance instantanée prédéterminée, cet étage d'amplification comprenant au moins un amplificateur et des circuits d'adaptation déterminant des paramètres de réglage dont la valeur influence des fonctions de transfert en puissance moyenne POUT(PIN), en phase PM(PIN), et en consommation PDC(PIN), de l'étage d'amplification,

caractérisé en ce que :

- il comprend, pour chaque amplificateur, des circuits d'adaptation procurant des valeurs optimales des paramètres de réglage de l'amplificateur,
- ces valeurs optimales étant déterminées à partir de valeurs d'un critère d'optimisation calculées pour chaque valeur de chaque paramètre de réglage, et de façon à représenter une optimisation du critère d'optimisation de l'amplificateur,
- les valeurs du critère d'optimisation étant calculées en fonction de l'espérance mathématique, avec la distribution statistique du signal d'entrée, d'au moins un paramètre d'optimisation lié à la puissance moyenne de sortie de l'amplificateur, cette espérance mathématique étant calculée avec ladite distribution statistique de puissance instantanée du signal d'entrée,
- il comprend plusieurs amplificateurs en parallèle dont le nombre N est déterminé en fonction d'une valeur de puissance moyenne de sortie à fournir par l'étage d'amplification de telle sorte que :

$$\sum_{1}^{N-1} POUTk \leq POUT \leq \sum_{1}^{N} POUTk$$

avec pour chaque amplificateur, POUTk une valeur de puissance moyenne de sortie de l'amplificateur est déterminée pour les valeurs optimales de chaque paramètre de réglage de l'amplificateur

Un étage d'amplification selon l'invention peut en particulier être exempt de détecteur d'enveloppe du signal d'entrée et de tout circuit permettant d'ajuster dynamiquement des tensions de polarisation et d'alimentation de l'amplificateur.

L'invention concerne également un procédé de fabrication d'un étage d'amplification de puissance d'un signal d'entrée à enveloppe variable, et un tel étage d'amplification caractérisés en combinaison par tout ou partie des caractéristiques mentionnées ci-dessus ou ci-après.

D'autres buts, caractéristiques et avantages de l'invention apparaîtront à la lecture de la description suivante d'un exemple non limitatif de réalisation d'un procédé selon l'invention et qui se réfère aux figures annexées dans lesquelles :

- la figure 1 est un logigramme des principales étapes d'un procédé selon un mode de réalisation de l'invention,
- la figure 2 est un diagramme schématique illustrant des variations de puissance moyenne de sortie POUT en fonction de la puissance moyenne d'entrée PIN d'un amplificateur,
- la figure 3 est un schéma illustrant un circuit d'adaptation de linéarisation associé à un amplificateur pour la mise en oeuvre d'un procédé selon l'invention,
- les figures 4a à 4c sont des diagrammes illustrant des exemples de distribution statistique (histogrammes des nombres d'occurrences de valeurs d'amplitude) de signaux selon trois schémas de modulation, respectivement 7 APSK ; 16 APSK et 16 QAM,
- la figure 5 est un schéma illustrant un étage d'amplification selon l'invention fabriqué par un procédé selon l'invention.

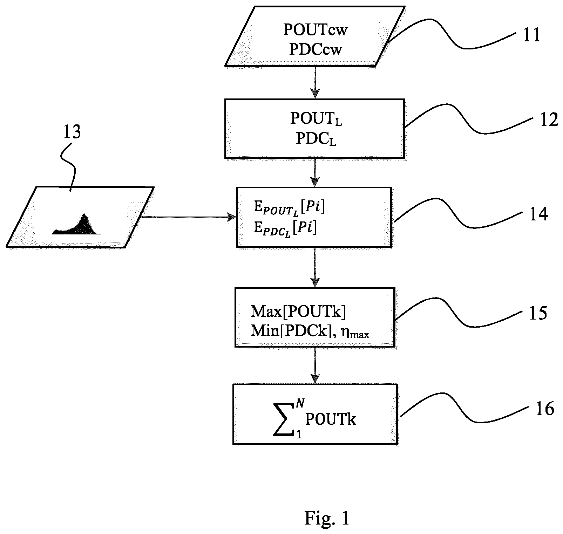

Un procédé de fabrication d'un étage d'amplification représenté figure 1 comprend une première étape 11 de caractérisation de chaque amplificateur 12 de l'étage d'amplification. Dans cette étape 11, on place un amplificateur 32 formé d'un transistor à effet de champ dans un banc de test (non représenté) du type désigné en anglais « load pull », par exemple tel que décrit par la publication « Caractérisation en puissance aux fréquences millimétriques de circuits nanométriques en technologie silicium » M. de Matos, E. Kerhervé, H. Lapuyade, J-B. Bégueret, Y. Deval, 10èmes journées pédagogiques CNFM (CNFM 2008), Nov 2008, St Malo, France. pp.111-116. On fait varier les valeurs des tensions de polarisation de drain Vd et de grille Vg et la valeur réelle de l'impédance de charge Z et de son facteur de puissance φ. À l'aide de ce banc de test, on mesure et on enregistre pour chaque valeur de chacun de ces paramètres de réglage Vd, Vg, Z, φ, les caractéristiques des variations de la puissance moyenne de sortie POUTcw(PIN) et de la consommation PDCcw(PIN) de l'amplificateur en fonction de la puissance moyenne PIN d'un signal d'entrée à enveloppe constante Scw.

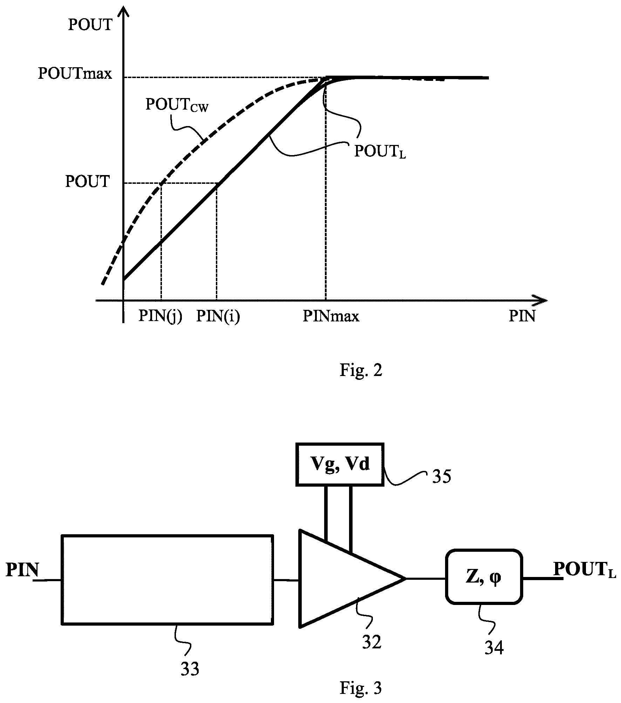

Un exemple de variation de la puissance moyenne POUTcw(PIN) de l'amplificateur pour un signal d'entrée à enveloppe constante est représenté sur la figure 2 par une courbe en pointillés. En pratique, cette variation peut être enregistrée sous la forme d'une table comprenant une colonne de valeurs de la puissance moyenne d'entrée PIN, une colonne de valeurs mesurées de la puissance moyenne de sortie POUTcw, et une colonne de valeurs mesurées de la consommation PDCcw.

En outre, lors de cette étape 11 de caractérisation, on mesure et on enregistre également dans cette même table avec le banc de test, et pour chaque valeur de chaque paramètre de réglage, des variations caractéristiques, en fonction de la puissance moyenne d'entrée PIN, du décalage de phase PMcw(PIN) de l'amplificateur à partir du signal d'entrée à enveloppe constante.

Il n'est cependant pas possible d'optimiser le réglage de l'amplificateur à partir de mesures effectuées avec un signal d'entrée à enveloppe constante, alors que cet amplificateur est destiné à être utilisé avec un signal d'entrée à enveloppe variable.

Lors de l'étape 12 subséquente, on choisit un circuit 33 de linéarisation placé en amont de l'amplificateur 32 et susceptible de procurer une forme de variation idéale en puissance moyenne de sortie $POUT_L(PIN)$ dérivable en tout point. Dans l'exemple de la figure 2, cette variation idéale $POUT_L$ est une variation comprenant une première partie linéaire (affine en réalité) jusqu'à une valeur maximale POUTmax de saturation de la puissance moyenne de sortie de l'amplificateur, avec une transition courbe dérivable en tout point entre la partie linéaire et la partie de saturation. D'autres exemples sont possibles, et il existe de nombreux circuits d'adaptation permettant d'obtenir diverses formes de variation idéale de la puissance moyenne de sortie de l'amplificateur.

En particulier, on choisit ce circuit 33 de linéarisation permettant d'obtenir une variation idéale en puissance moyenne de sortie en fonction d'un critère de performance que l'on souhaite imposer à l'amplificateur, par exemple une valeur du rapport signal/bruit ou d'un taux d'intermodulation à la puissance maximum de saturation, et dont on sait qu'il est satisfait pour ladite variation idéale. Ainsi, dans l'exemple représenté figure 2, on sait en particulier qu'il est possible d'obtenir une valeur du rapport signal/bruit à la puissance de saturation qui est par exemple égale à 15 dB en choisissant le circuit 33 de linéarisation de façon appropriée. Ainsi, en adoptant ce circuit 33 de linéarisation, on assure que l'amplificateur 32 fournira un signal en sortie qui sera conforme à ce critère de performance. Par ailleurs, le circuit 33 de linéarisation est choisi de façon à obtenir un décalage de phase de valeur prédéterminée, de préférence nulle, dans le signal de sortie amplifié.

Un procédé pour choisir un tel circuit 33 de linéarisation est décrit dans la demande de brevet français FR1453773. De nombreuses autres variantes connues de linéarisation peuvent être utilisées à ce titre. Les caractéristiques des circuits électroniques permettant d'obtenir la forme de variation choisie peuvent être déterminées dans le cas d'un signal hyperfréquence notamment comme décrit par C.W.Park, and al., "An Independently Controllable AM/AM and AM/PM Predistortion Linearizer for CDMA 2000 Multi-Carrier Applications", IEEE 2001. À des fréquences moins élevées, ces caractéristiques peuvent être déterminées à partir de systèmes numériques, tels que des tables d'équivalence (O.Hammi, S.Boumaiza, F.M.Ghannouchi, "On the Robustness of Digital Predistortion Function Synthesis and Average Power Tracking for Highly Nonlinear Power Amplifiers", IEEE transactions on microwave theory and techniques, vol. 55, No. 6, june 2007 ; Nagata Y., "linear amplification technique for digital mobile communications", 39th IEEE vehicular technology conférence, May. 1989, pp. 159-164 ; Faulkner M., Mattson T., Yates W., "adaptive linearization using predistortion", 40th of the IEEE vehicular technology conférence, May. 1990, pp. 35-40).

En variante, on peut également utiliser un circuit linéariseur paramétrable, tel que les linéariseurs Lintech (US) de la série WAFL, compatible avec la gamme de fréquence et la gamme de puissance moyenne prévues pour le signal d'entrée, et pour lequel les variations des fonctions de transfert (ou "galbes") en puissance moyenne et en décalage de phase qu'il produit sont prédéterminées et connues pour différentes valeurs des paramètres ajustables de ce circuit linéariseur paramétrable. Un jeu des paramètres du circuit linéariseur est choisi pour que les fonctions de transfert en puissance moyenne et en décalage de phase produites par ce circuit linéariseur correspondent au plus près à la variation idéale recherchée. Le choix d'un jeu des paramètres ajustables du circuit linéariseur permet donc de choisir une variation idéale en puissance moyenne $POUT_L(PIN)$ dérivable en tout point. En pratique, cette variation idéale en puissance moyenne de sortie $POUT_L(PIN)$ est représentée par une colonne supplémentaire des valeurs de la puissance moyenne de sortie $POUT_L$ selon cette variation idéale dans la table mentionnée ci-dessus.

Une fois sélectionnée la variation idéale en puissance moyenne $POUT_L(PIN)$, il est possible, si la consommation est choisie comme paramètre d'optimisation, de recalculer, pour chaque valeur de chaque paramètre de réglage Vg, Vd, Z, φ, une variation idéal de la consommation $PDC_L(PIN)$ en fonction de la puissance moyenne d'entrée PIN, à partir de ladite variation idéale en puissance moyenne $POUT_L(PIN)$ et desdites variations mesurées POUTcw(PIN) et PDCcw(PIN). En effet, la table susmentionnée met en relation les valeurs de la consommation mesurée pour le signal à enveloppe constante PDCcw en fonction des valeurs de la puissance de sortie mesuré pour le signal à enveloppe constante POUTcw.

Par exemple la table susmentionnée est la suivante :

| Ligne i, j | PIN | POUT$_{cw}$ | PDC$_{cw}$ | POUT$_L$ | PDC$_L$ |
|---|---|---|---|---|---|
| 1 | 0 | 3 | 2 | 2 | 1 |
| 2 | 2 | 8 | 6 | 5 | 4 |
| 3 | 4 | 12 | 10 | 7 | 6 |
| 4 | 6 | 16 | 13 | 10 | 8 |
| 5 | 8 | 19 | 16 | 12 | 10 |
| 6 | 10 | 22 | 18 | 15 | 13 |
| 7 | 12 | 24 | 19 | 18 | 14 |
| 8 | 14 | 25 | 20 | 20 | 16 |
| 9 | 16 | 26 | 20 | 23 | 16 |
| 10 | 18 | 26 | 20 | 25 | 20 |
| 11 | 20 | 26 | 20 | 26 | 20 |

Pour calculer PDC$_L$(i) à la ligne i, on utilise par exemple la formule d'interpolation linéaire suivante :

$$PDC_L(i) = POUT_L(i) \times [POUTcw(j) - POUTcw(j-1)] / [PDCcw(j) - PDCcw(j-1)]$$

avec j la ligne sélectionnée telle que :

$$POUTcw(j) \geq POUT_L(i) \geq POUTcw(j-1)$$

D'autres formes d'interpolation peuvent être choisies.

Si les valeurs mesurées et celles représentatives de la variation idéale sont suffisamment nombreuses, il existera, comme représenté figure 2, une valeur de j pour laquelle :

$$POUTcw(PIN(j)) = POUT_L(PIN(i)),$$

et on pourra prendre PDC$_L$(PIN(i)) = PDCcw(PIN(j)).

On utilise ensuite (étape 13 figure 1) la distribution statistique de puissance instantanée du signal d'entrée à enveloppe variable à amplifier, qui est prédéterminée, notamment selon le schéma de modulation, pour calculer un critère d'optimisation lors d'une étape 14.

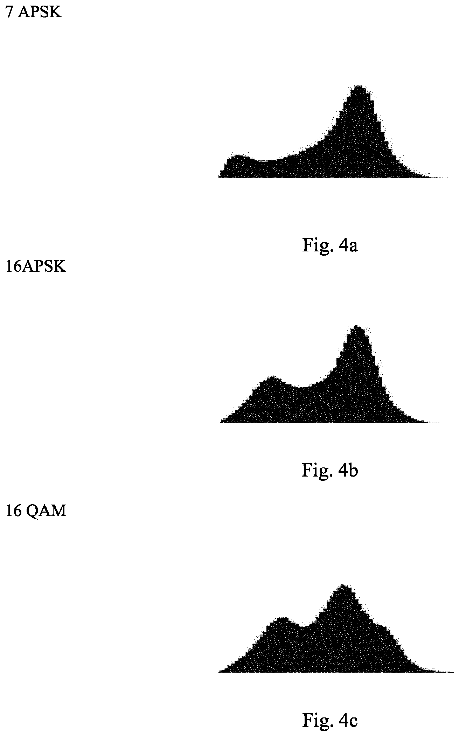

En effet, il s'avère que les signaux, tels que les signaux de communication, modulés sur une (ou plusieurs) porteuse(s) présentent une distribution statistique de puissance instantanée qui ne dépend que du schéma de modulation. La figure 4a illustre ainsi la forme des histogrammes des nombres d'occurrences de valeurs d'amplitude de signaux modulés selon une modulation 7APSK (modulation d'amplitude et de phase à 7 symboles) ; la figure 4b illustre la forme des histogrammes des nombres d'occurrences de valeurs d'amplitude de signaux modulés selon une modulation 16APSK (modulation d'amplitude et de phase à 16 symboles) ; la figure 4c illustre la forme des histogrammes des nombres d'occurrences de valeurs d'amplitude de signaux modulés selon une modulation 16QAM (modulation d'amplitude en quadrature à 16 symboles). Connaissant le schéma de modulation, ou plus généralement la distribution statistique de puissance instantanée d'un signal, on connaît la densité de probabilité $D_{Se}$ (Pi) de la puissance moyenne du signal *Se* en fonction de chaque valeur de puissance instantanée Pi du signal *Se.* En pratique cette distribution statistique peut se présenter sous forme d'une table de valeurs discrètes à partir de laquelle on réalise des calculs numériques, ou d'une fonction analytique ou d'une approximation analytique, par exemple polynomiale de la densité de probabilité. On peut donc calculer (par calcul numérique sur des valeurs discrètes ou avec une fonction analytique) l'espérance mathématique de la puissance moyenne d'un tel signal *Se.*

Selon l'invention on utilise la densité de probabilité $D_{Se}$ (Pi) de la puissance moyenne du signal *Se* d'entrée à enveloppe variable à amplifier en fonction de chaque valeur de puissance instantanée Pi de ce signal *Se* d'entrée à enveloppe variable à amplifier pour calculer, lors de l'étape 14, l'espérance mathématique d'au moins un paramètre d'optimisation lié à la puissance moyenne du signal de sortie amplifié, à partir au moins de ladite variation idéale en puissance moyenne POUT$_L$(PIN). Avantageusement au moins un tel paramètre d'optimisation est choisi parmi la puissance moyenne de sortie POUTk de l'amplificateur et la consommation PDCk de l'amplificateur.

Le choix de chaque paramètre d'optimisation dépend du critère d'optimisation de l'amplificateur que l'on veut retenir, qui dépend lui-même de l'application de l'étage d'amplification à fabriquer.

Par exemple, notamment pour les applications spatiales, on utilise préférentiellement à titre de critère d'optimisation un rendement électrique déterminé par le rapport entre la puissance moyenne de sortie POUTk et la consommation PDCk. Dans ce cas, on utilise donc à titre de paramètre d'optimisation la puissance moyenne de sortie POUTk et la consommation PDCk de l'amplificateur. On calcule alors lors de l'étape 14, pour chaque valeur de chaque paramètre de réglage Vd, Vg, Z, φ, l'espérance mathématique de ces paramètres d'optimisation selon les formules suivantes :

$$E_{POUT_L}[Pi] = \int_0^\infty P_{OUT_L}(Pi).D_{Se}(Pi).dPi$$

$$E_{PDC_L}[Pi] = \int_0^\infty PDC_L(Pi).D_{Se}(Pi).dPi$$

Et le rendement η :

$$\eta = \frac{E_{POUT_L}[Pi]}{E_{PDC_L}[Pi]}$$

En pratique ces formules sont mises en oeuvre par applications de formules statistiques sur les tables de valeurs donnant $D_{Se}$ (Pi) et POUT$_L$ (Pi) à l'aide d'un tableur. En variante, on peut réaliser un calcul au moins pour partie analytique, à partir d'une fonction analytique (ou d'une approximation analytique) de la densité de probabilité $D_{Se}$ (Pi) et d'une approximation analytique, par exemple polynomiale, de $P_{OUT_L}$(Pi).

En variante, on peut utiliser un autre critère d'optimisation que le rendement. Par exemple on peut utiliser uniquement la valeur de la puissance moyenne de sortie POUTk à titre de critère d'optimisation, auquel cas on ne calcule lors de l'étape 14 que l'espérance mathématique de la puissance moyenne de sortie $E_{POUT_L}$[Pi]. Si on utilise uniquement la consommation PDCk à titre de critère d'optimisation, on ne calcule lors de l'étape 14 que l'espérance mathématique de la consommation $E_{PDC_L}$[Pi]. Si on utilise uniquement la puissance dissipée DISSk à titre de critère d'optimisation, on ne calcule lors de l'étape 14 que l'espérance mathématique de la puissance dissipée :

$$E_{DISS_L}[Pi] = E_{PDC_L}[Pi] - E_{POUT_L}[Pi]$$

Il est à noter que chaque espérance mathématique est calculée à partir de la variation idéale du paramètre d'optimisation correspondant, c'est-à-dire au moins à partir de la variation idéale en puissance moyenne POUT$_L$(PIN). En utilisant ainsi un amplificateur 32 corrigé par des circuits 33, 34 et 35 d'adaptation on peut en effet utiliser une telle variation idéale pour calculer chaque espérance mathématique utilisée pour calculer un critère d'optimisation, tout en garantissant que l'amplificateur satisfera à des critères de performance prédéterminés liés au choix précédemment effectué de cette variation idéale. Par exemple, en utilisant une variation idéale linéarisée comme indiqué ci-dessus, on peut garantir que l'amplificateur procurera un rapport signal/bruit ou un taux d'intermodulation prédéterminé pour toute valeur de sa puissance moyenne de sortie.

À l'issue de l'étape 14, les différents calculs du critère d'optimisation effectués pour chaque valeur de chaque paramètre de réglage Vd, Vg, Z, φ sont enregistrés dans une table.

Lors de l'étape 15 subséquente, une combinaison optimale des valeurs des paramètres de réglage Vd, Vg, Z, φ est déterminée à partir de la table de valeurs calculées du critère d'optimisation, pour optimiser ce critère d'optimisation de l'amplificateur. Ainsi, on détermine par exemple dans la table la combinaison optimale qui procure la plus grande valeur numérique η$_{max}$ du rendement η ; ou celle qui procure la plus grande valeur numérique Max[POUTk] de la puissance moyenne de sortie POUTk ; ou celle qui procure la plus faible valeur numérique Min[PDCk] de la consommation PDCk.

On obtient de façon simple une optimisation précise et complète du réglage de l'amplificateur, prenant en considération les différents paramètres de réglage et des critères de performance de l'amplificateur, et ce quel que soit ce critère d'optimisation et quels que soient la technologie de l'amplificateur et les paramètres de réglage correspondants.

Ainsi, une telle combinaison optimale de valeurs de paramètres de réglage d'un amplificateur peut être déterminée conformément au procédé selon l'invention non seulement pour les amplificateurs formés de transistors à effet de champ (circuits à état solide), mais également pour les tubes à ondes progressives, les paramètres de réglage étant alors typiquement le courant de faisceau Ik dicté par la tension $VA_0$, la tension d'hélice Vh et les tensions de collecteurs Vc1,2,3,4. Les étapes 11 à 15 peuvent en effet être mises en oeuvre avec ces paramètres de réglage.

De même, rien n'empêche de choisir toute autre forme de variation idéale que celle représentée figure 2, selon les critères de performance requis. Par exemple, il est possible de prévoir une zone de surpuissance au sommet de la portion linéarisée de la variation idéale pour augmenter la puissance moyenne de sortie au voisinage de la saturation de façon plus importante que cette variation linéarisée. Cela étant, il convient de choisir une variation idéale qui d'une part peut être réalisée par des circuits électroniques d'adaptation, et d'autre part correspond à une réalité physique, c'est-à-dire ne présente pas de discontinuité et est dérivable en tout point.

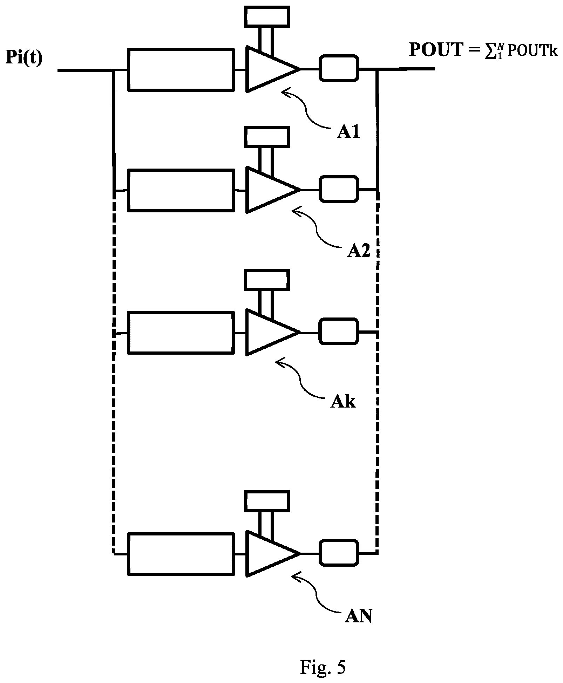

Une fois déterminée la combinaison optimale des paramètres de réglage de chaque amplificateur k, on connaît la valeur de la puissance moyenne de sortie POUTk = $E_{POUT_L}[Pi]$ de l'amplificateur correspondant à cette combinaison optimale, et on détermine lors de l'étape 16 le nombre N d'amplificateur(s) A1, A2,...Ak,..., AN, à utiliser dans l'étage d'amplification de telle sorte que la puissance moyenne de sortie POUT de l'étage d'amplification puisse être obtenue par la mise en parallèle de plusieurs amplificateurs A1, A2,...Ak,..., AN, comme représenté figure 5, si nécessaire.

Le nombre N d'amplificateurs A1, A2,...Ak,..., AN en parallèle est déterminé de telle sorte que :

$$\sum_1^{N-1} POUTk \leq POUT \leq \sum_1^N POUTk$$

De préférence, lorsque plusieurs amplificateurs en parallèle sont utilisés pour fabriquer l'étage d'amplification, tous les amplificateurs sont identiques. Rien n'empêche cependant d'utiliser des amplificateurs différents, ce qui nécessite cependant de réitérer les étapes d'optimisation des paramètres de réglage pour chaque amplificateur.

Ainsi dans un procédé selon l'invention, étant donnés une puissance moyenne de sortie POUT, au moins un critère de performance (par exemple un rapport signal/bruit et/ou un taux d'intermodulations), et une distribution statistique de puissance instantanée, on détermine une combinaison optimale des paramètres de réglage de chaque amplificateur k, une valeur de puissance moyenne de sortie POUTk = $E_{POUT_L}[Pi]$ correspondante de chaque amplificateur, et un nombre N d'amplificateurs à utiliser pour obtenir la puissance moyenne de sortie POUT de l'étage d'amplification. Il est à noter à ce titre que la puissance moyenne du signal d'entrée n'est pas une contrainte donnée, mais est déterminée pour correspondre à la combinaison optimale des paramètres de réglage de chaque amplificateur et à la puissance moyenne de sortie POUTk correspondante.

Comme représenté figure 3, lorsqu'on utilise des transistors à effet de champ à titre d'amplificateurs, l'étage d'amplification comprend pour chaque amplificateur 32, un circuit 33 de linéarisation en amont (permettant notamment d'obtenir une variation idéale de la puissance moyenne de sortie de l'amplificateur), une impédance de charge 34 en sortie et un dispositif 35 de polarisation fournissant les tensions Vg, Vd de polarisation du transistor 32. Le circuit 33 de linéarisation, l'impédance de charge 34 en sortie et le dispositif 35 de polarisation sont des circuits d'adaptation de l'étage d'amplification. Ces circuits 33, 34, 35 d'adaptation présentent des caractéristiques fixes correspondant aux valeurs optimales des paramètres de réglage et qui ne dépendent pas en particulier dynamiquement des caractéristiques du signal d'entrée. Bien entendu, si l'étage d'amplification comprend une pluralité de tels amplificateurs 32 identiques, il est possible d'utiliser un seul et même circuit 33 de linéarisation commun aux différents amplificateurs 32, un seul et même circuit en sortie constituant l'impédance de charge 34 pour tous les amplificateurs 32, et un seul et même circuit 35 de polarisation fournissant les différentes tensions de polarisation aux différents transistors en parallèle.

Il est à noter que dans un procédé selon l'invention, on privilégie l'optimisation des paramètres de réglage de chaque amplificateur par rapport au nombre des amplificateurs éventuellement utilisés en parallèle et par rapport à la valeur de la puissance moyenne de sortie ou à celle de la puissance moyenne d'entrée. En effet, l'inventeur a pu démontrer, contrairement aux principes généralement admis à ce titre selon lesquels il convient de minimiser le nombre d'amplificateurs de puissance embarqués, qu'il s'avère qu'une telle optimisation permet en pratique un gain de performance tel qu'il compense largement le surcoût et/ou le surpoids éventuellement entraîné par l'utilisation de plusieurs amplificateurs en parallèle, et ce y compris dans les applications pour des systèmes embarqués, notamment pour des systèmes spatiaux.

## Revendications

1. - Procédé de fabrication d'un étage d'amplification de puissance d'un signal d'entrée à enveloppe variable présentant une distribution statistique de puissance instantanée prédéterminée, cet étage d'amplification comprenant au moins un amplificateur (32) et des circuits (33, 34, 35) d'adaptation déterminant des paramètres de réglage dont la valeur influence des fonctions de transfert en puissance moyenne POUT(PIN), en phase PM(PIN), et en consommation PDC(PIN), de l'étage d'amplification,

comprenant les étapes suivantes :

- pour chaque amplificateur (32), sélection d'une forme de variation idéale en puissance moyenne POUTL (PIN) dérivable en tout point et pouvant être procurée par un choix approprié des circuits (33, 34, 35) d'adaptation,
- pour chaque amplificateur (32), calcul, pour chaque valeur de chaque paramètre de réglage et pour chaque valeur PIN de puissance moyenne d'entrée, d'une valeur d'un critère d'optimisation en fonction de l'espérance mathématique d'au moins un paramètre d'optimisation lié à la puissance moyenne de sortie de l'amplificateur, cette espérance mathématique étant calculée avec ladite distribution statistique de puissance instantanée du signal d'entrée et à partir au moins de ladite variation idéale en puissance moyenne POUTL (PIN),
- pour chaque amplificateur (32), sélection à partir de chaque valeur du critère d'optimisation, d'une valeur optimale de chaque paramètre de réglage représentant une optimisation du critère d'optimisation de l'amplificateur (32), et détermination d'une valeur de puissance moyenne de sortie correspondante de l'amplificateur,
- fabrication de l'étage d'amplification avec un nombre N d'amplificateur(s) (32) en parallèle déterminé en fonction d'une valeur de puissance moyenne de sortie à fournir par l'étage d'amplification, et avec, pour chaque amplificateur (32), des circuits (33, 34, 35) d'adaptation procurant lesdites valeurs optimales des paramètres de réglage.

2. - Procédé selon la revendication 1, **caractérisé en ce que** le critère d'optimisation est choisi parmi la puissance moyenne de sortie POUTk de l'amplificateur (32) ; la consommation PDCk de l'amplificateur (32) ; la puissance dissipée par l'amplificateur (32) ; et un rendement de l'amplificateur (32) déterminé par le rapport entre la puissance moyenne de sortie POUTk et la consommation PDCk ; et leurs combinaisons.

3. - Procédé selon la revendication 2, **caractérisé en ce qu'**au moins un paramètre d'optimisation est choisi parmi la puissance moyenne de sortie POUTk de l'amplificateur (32) et la consommation PDCk de l'amplificateur (32), chaque valeur du critère d'optimisation étant calculée en fonction de l'espérance mathématique, avec la distribution statistique du signal d'entrée, de ce paramètre d'optimisation à partir au moins de ladite variation idéale en puissance moyenne POUTL (PIN).

4. - Procédé selon l'une des revendications 1 à 3, **caractérisé en ce qu'**au moins un paramètre d'optimisation est la consommation PDCk de l'amplificateur (32), et **en ce qu'**il comprend en outre les étapes suivantes :

- caractérisation (11) de chaque amplificateur (32), à l'aide d'un banc de test mesurant et enregistrant, pour chaque valeur de chaque paramètre de réglage, des variations caractéristiques, en fonction de la puissance moyenne d'entrée PIN, de la puissance moyenne POUTcw(PIN) et de la consommation PDCcw(PIN) à partir d'un signal à enveloppe constante appliqué à l'entrée du banc de test,
- pour chaque amplificateur (32), calcul, pour chaque valeur de chaque paramètre de réglage, d'une variation idéale de la consommation PDCL (PIN) en fonction de la puissance moyenne d'entrée PIN, à partir de ladite variation idéale en puissance moyenne POUTL (PIN) et desdites variations caractéristiques,

et **en ce que** chaque valeur du critère d'optimisation est déterminée en fonction de l'espérance mathématique, avec la distribution statistique du signal d'entrée, de la consommation PDCL (PIN) obtenue à partir de ladite variation idéale de la consommation PDCL (PIN) en fonction de la puissance moyenne d'entrée PIN.

5. - Procédé selon la revendication 4, **caractérisé en ce qu'**il comprend en outre une étape de caractérisation de chaque amplificateur (32), à l'aide d'un banc de test mesurant et enregistrant, pour chaque valeur de chaque paramètre de réglage, des variations caractéristiques, en fonction de la puissance moyenne d'entrée PIN, du décalage de phase PMcw(PIN) de l'amplificateur (32) à partir du signal d'entrée à enveloppe constante, et **en ce que** les circuits (33, 34, 35) d'adaptation sont choisis pour obtenir un décalage de phase de valeur prédéterminée, notamment nulle.

6. - Procédé selon l'une des revendications 1 à 5, **caractérisé en ce que** ladite forme de variation idéale en puissance moyenne POUTL (PIN) est une variation affine jusqu'à une valeur supérieure de début de saturation.

7. - Procédé selon l'une des revendications 1 à 6, **caractérisé en ce que** le signal d'entrée comprend une modulation selon un schéma de modulation prédéterminé.

8. - Procédé selon la revendication 7, **caractérisé en ce que** le signal d'entrée à enveloppe variable présente une densité de probabilité de puissance instantanée du signal d'entrée déterminée en fonction du schéma de la modulation du signal de communication.

9. - Procédé selon l'une des revendications 1 à 8, **caractérisé en ce que** ladite forme de variation idéale en puissance moyenne POUTL (PIN) est choisie en fonction d'un critère de performance de l'étage d'amplification choisi parmi une valeur d'un rapport signal /bruit et un taux d'intermodulation.

10. - Procédé selon l'une des revendications 1 à 9, **caractérisé en ce que** le signal d'entrée est un signal hyperfréquence.

11. - Procédé selon l'une des revendications 1 à 10, **caractérisé en ce qu'**au moins un amplificateur (32) étant un transistor, lesdits paramètres de réglage sont choisis dans le groupe formé d'au moins une tension de polarisation et d'au moins une caractéristique d'impédance de charge.

12. - Procédé selon l'une des revendications 1 à 11, **caractérisé en ce qu'**au moins un amplificateur (32) étant un tube à ondes progressives, lesdits paramètres de réglage sont choisis dans le groupe formé d'un courant de faisceau, d'une tension d'hélice, et d'une tension de collecteur.

13. - Procédé selon l'une des revendications 1 à 12, **caractérisé en ce que** l'étage d'amplification délivrant une puissance moyenne de sortie POUT prédéterminée, pour chaque amplificateur (32), une valeur de puissance moyenne de sortie POUTk de l'amplificateur (32) est déterminée pour les valeurs optimales de chaque paramètre de réglage, et **en ce que** le nombre N d'amplificateur(s) en parallèle de l'étage d'amplification est choisi tel que :

$$\sum_{1}^{N-1} POUTk \leq POUT \leq \sum_{1}^{N} POUTk$$

14. - Procédé selon l'une des revendications 1 à 13, **caractérisé en ce que** l'étage d'amplification est fabriqué avec une pluralité d'amplificateurs (32) identiques.

15. - Étage d'amplification de puissance d'un signal d'entrée à enveloppe variable présentant une distribution statistique de puissance instantanée prédéterminée, cet étage d'amplification comprenant une pluralité d'amplificateur (32) et des circuits (33, 34, 35) d'adaptation déterminant des paramètres de réglage dont la valeur influence des fonctions de transfert en puissance moyenne POUT(PIN), en phase PM(PIN), et en consommation PDC(PIN), de l'étage d'amplification,
**caractérisé en ce que** :

- il comprend, pour chaque amplificateur (32), des circuits (33, 34, 35) d'adaptation procurant des valeurs optimales des paramètres de réglage de l'amplificateur (32),
- ces valeurs optimales étant déterminées à partir de valeurs d'un critère d'optimisation calculées pour chaque valeur de chaque paramètre de réglage, et de façon à représenter une optimisation du critère d'optimisation de l'amplificateur (32),
- les valeurs du critère (d'optimisation étant calculées en fonction de l'espérance mathématique d'au moins un paramètre d'optimisation lié à la puissance moyenne de sortie de l'amplificateur, cette espérance mathématique étant calculée avec ladite distribution statistique de puissance instantanée du signal d'entrée et à partir au moins d'une variation idéale en puissance moyenne POUT$_L$(PIN) de l'amplificateur (32),
- il comprend plusieurs amplificateurs (32) en parallèle dont le nombre N est déterminé en fonction d'une valeur de puissance moyenne de sortie à fournir par l'étage d'amplification de telle sorte que :

$$\sum_{1}^{N-1} POUTk \leq POUT \leq \sum_{1}^{N} POUTk$$

avec pour chaque amplificateur, POUTk une valeur de puissance moyenne de sortie de l'amplificateur est déterminée pour les valeurs optimales de chaque paramètre de réglage de l'amplificateur (32) et POUT une puissance moyenne de sortie prédéterminée.

**Patentansprüche**

1. Verfahren zum Herstellen einer Verstärkungsstufe für die Leistung eines Eingangssignals mit variabler Hüllkurve, das eine vorbestimmte statistische Verteilung der momentanen Leistung aufweist, wobei die Verstärkungsstufe mindestens einen Verstärker (32) und Anpassungsschaltungen (33, 34, 35) umfasst, die Einstellparameter bestimmen, deren Wert die Übertragungsfunktionen der durchschnittlichen Leistung POUT(PIN), der Phase PM(PIN) und des Verbrauchs PDC(PIN) der Verstärkungsstufe beeinflusst,
umfassend die folgenden Schritte:

    - für jeden Verstärker (32), Auswählen einer Form der idealen Variation der durchschnittlichen Leistung POUTL (PIN), die an jedem Punkt ableitbar ist und die durch eine geeignete Auswahl der Anpassungsschaltungen (33, 34, 35) bereitgestellt werden kann,
    - für jeden Verstärker (32), Berechnen eines Werts eines Optimierungskriteriums für jeden Wert jedes Einstellparameters und für jeden Wert PIN der durchschnittlichen Eingangsleistung entsprechend des mathematischen Erwartungswerts mindestens eines Optimierungsparameters, der mit der durchschnittlichen Ausgangsleistung des Verstärkers verbunden ist, wobei dieser mathematische Erwartungswert mit der statistischen Verteilung der momentanen Leistung des Eingangssignals und anhand mindestens der idealen Variation der durchschnittlichen Leistung POUTL (PIN) berechnet wird,
    - für jeden Verstärker (32), Auswählen eines optimalen Werts jedes Einstellparameters, der eine Optimierung des Optimierungskriteriums des Verstärkers (32) darstellt, anhand jedes Werts des Optimierungskriteriums und Bestimmen eines entsprechenden durchschnittlichen Ausgangsleistungswerts des Verstärkers,
    - Erzeugen der Verstärkungsstufe mit einer Anzahl N parallel geschalteter Verstärker (32), die entsprechend eines von der Verstärkungsstufe zu liefernden durchschnittlichen Ausgangsleistungswerts bestimmt wird, und mit Anpassungsschaltungen (33, 34, 35), die die optimalen Werte der Einstellparameter bereitstellen, für jeden Verstärker (32).

2. Verfahren nach Anspruch 1, **dadurch gekennzeichnet, dass** das Optimierungskriterium aus der durchschnittlichen Ausgangsleistung POUTk des Verstärkers (32), dem Verbrauch PDCk des Verstärkers (32), der vom Verstärker (32) abgegebenen Leistung, und einem Wirkungsgrad des Verstärkers (32), der durch das Verhältnis zwischen der durchschnittlichen Ausgangsleistung POUTk und dem Verbrauch PDCk bestimmt wird, und Kombinationen davon ausgewählt wird.

3. Verfahren nach Anspruch 2, **dadurch gekennzeichnet, dass** mindestens ein Optimierungsparameter aus der durchschnittlichen Ausgangsleistung POUTk des Verstärkers (32) und dem Verbrauch PDCk des Verstärkers (32) ausgewählt wird, wobei jeder Wert des Optimierungskriteriums entsprechend dem mathematischen Erwartungswert dieses Optimierungsparameters anhand mindestens der idealen Variation der durchschnittlichen Leistung POUTL (PIN) mit der statistischen Verteilung des Eingangssignals berechnet wird.

4. Verfahren nach einem der Ansprüche 1 bis 3, **dadurch gekennzeichnet, dass** mindestens ein Optimierungsparameter der Verbrauch PDCk des Verstärkers (32) ist, und dadurch, dass es ferner die folgenden Schritte umfasst:

    - Charakterisieren (11) jedes Verstärkers (32) mit Hilfe eines Prüfstands, der für jeden Wert jedes Einstellparameters charakteristische Variationen entsprechend der durchschnittlichen Eingangsleistung PIN, der durchschnittlichen Leistung POUTcw(PIN) und dem Verbrauch PDCcw(PIN) anhand eines Signals mit konstanter Hüllkurve, das an den Eingang des Prüfstands angelegt wird, misst und aufzeichnet,
    - für jeden Verstärker (32), Berechnen einer idealen Variation des Verbrauchs PDCL (PIN) entsprechend der durchschnittlichen Eingangsleistung PIN anhand der idealen Variation der durchschnittlichen Leistung POUTL (PIN) und der charakteristischen Variationen für jeden Wert jedes Einstellparameters,

    und dadurch, dass jeder Wert des Optimierungskriteriums entsprechend des mathematischen Erwartungswerts des Verbrauchs PDCL (PIN), der anhand der idealen Variation des Verbrauchs PDCL (PIN) entsprechend der durchschnittlichen Eingangsleistung PIN erhalten wird, mit der statistischen Verteilung des Eingangssignals bestimmt wird.

5. Verfahren nach Anspruch 4, **dadurch gekennzeichnet, dass** es ferner einen Schritt des Charakterisierens jedes Verstärkers (32) mit Hilfe eines Prüfstands umfasst, der für jeden Wert jedes Einstellparameters charakteristische Variationen, entsprechend der durchschnittlichen Eingangsleistung PIN, der Phasenverschiebung PMcw(PIN) des Verstärkers (32) anhand des Eingangssignals mit konstanter Hüllkurve misst und aufzeichnet, und dadurch, dass die Anpassungsschaltungen (33, 34, 35) so ausgewählt werden, dass sie eine Phasenverschiebung mit einem vorbestimmten Wert, insbesondere Null, erhalten.

6. Verfahren nach einem der Ansprüche 1 bis 5, **dadurch gekennzeichnet, dass** die Form der idealen Variation der durchschnittlichen Leistung POUTL (PIN) eine affine Variation bis zu einem größeren Sättigungsanfangswert ist.

7. Verfahren nach einem der Ansprüche 1 bis 6, **dadurch gekennzeichnet, dass** das Eingangssignal eine Modulation gemäß einem vorbestimmten Modulationsschema umfasst.

8. Verfahren nach Anspruch 7, **dadurch gekennzeichnet, dass** das Eingangssignal mit variabler Hüllkurve eine Wahrscheinlichkeitsdichte der momentanen Leistung des Eingangssignals aufweist, die entsprechend des Modulationsschemas des Kommunikationssignals bestimmt wird.

9. Verfahren nach einem der Ansprüche 1 bis 8, **dadurch gekennzeichnet, dass** die Form der idealen Variation der durchschnittlichen Leistung POUTL (PIN) entsprechend eines Leistungskriteriums der Verstärkungsstufe ausgewählt wird, das aus einem Wert eines Signal-Rausch-Verhältnisses und einer Intermodulationsrate ausgewählt wird.

10. Verfahren nach einem der Ansprüche 1 bis 9, **dadurch gekennzeichnet, dass** das Eingangssignal ein Mikrowellenfrequenzsignal ist.

11. Verfahren nach einem der Ansprüche 1 bis 10, **dadurch gekennzeichnet, dass** mindestens ein Verstärker (32) ein Transistor ist, wobei die Einstellparameter aus der Gruppe ausgewählt werden, die aus mindestens einer Polarisationsspannung und mindestens einer Lastimpedanzcharakteristik besteht.

12. Verfahren nach einem der Ansprüche 1 bis 11, **dadurch gekennzeichnet, dass** mindestens ein Verstärker (32) eine Wanderfeldröhre ist, wobei die Einstellparameter aus der Gruppe ausgewählt werden, die aus einem Strahlstrom, einer Helixspannung und einer Kollektorspannung besteht.

13. Verfahren nach einem der Ansprüche 1 bis 12, **dadurch gekennzeichnet, dass** die Verstärkungsstufe, die eine vorbestimmte durchschnittliche Ausgangsleistung POUT für jeden Verstärker (32) bereitstellt, ein durchschnittlicher Ausgangsleistungswert POUTk des Verstärkers (32) für die optimalen Werte jedes Einstellparameters bestimmt wird, und dadurch, dass die Anzahl N der parallel geschalteten Verstärker der Verstärkungsstufe so ausgewählt wird, dass:

$$\sum_1^{N-1} POUTk \leq POUT \leq \sum_1^N POUTk$$

14. Verfahren nach einem der Ansprüche 1 bis 13, **dadurch gekennzeichnet, dass** die Verstärkungsstufe mit einer Vielzahl von identischen Verstärkern (32) hergestellt wird.

15. Verstärkungsstufe für die Leistung eines Eingangssignals mit variabler Hüllkurve, das eine vorbestimmte statistische Verteilung der momentanen Leistung aufweist, wobei die Verstärkungsstufe eine Vielzahl von Verstärkern (32) und Anpassungsschaltungen (33, 34, 35) umfasst, die Einstellparameter bestimmen, deren Wert die Übertragungsfunktionen der durchschnittlichen Leistung POUT(PIN), der Phase PM(PIN) und des Verbrauchs PDC(PIN) der Verstärkungsstufe beeinflusst,
**dadurch gekennzeichnet, dass**:

- sie für jeden Verstärker (32) Anpassungsschaltungen (33, 34, 35) umfasst, die optimale Werte der Einstellparameter des Verstärkers (32) bereitstellen,
- wobei diese optimalen Werte anhand von Werten eines Optimierungskriteriums bestimmt werden, die für jeden Wert jedes Einstellparameters berechnet werden, so dass sie eine Optimierung des Optimierungskriteriums des Verstärkers (32) darstellen,
- wobei die Werte des Optimierungskriteriums entsprechend des mathematischen Erwartungswerts mindestens eines Optimierungsparameters berechnet werden, der mit der durchschnittlichen Ausgangsleistung des Verstärkers verbunden ist, wobei dieser mathematische Erwartungswert mit der statistischen Verteilung der momentanen Leistung des Eingangssignals und anhand mindestens einer idealen Variation der durchschnittlichen Leistung POUT$_L$(PIN) des Verstärkers (32) berechnet wird,
- sie mehrere parallel geschaltete Verstärker (32) umfasst, deren Anzahl N entsprechend eines von der Verstärkungsstufe zu liefernden durchschnittlichen Ausgangsleistungswerts so bestimmt wird, dass:

$$\sum_1^{N-1} POUTk \leq POUT \leq \sum_1^{N} POUTk$$

wobei für jeden Verstärker POUTk ein durchschnittlicher Ausgangsleistungswert des Verstärkers für die optimalen Werte jedes Einstellparameters des Verstärkers (32) und POUT eine vorbestimmte durchschnittliche Ausgangsleistung bestimmt wird.

## Claims

1. A method for manufacturing a power amplification stage of a varying envelope input signal having a predetermined statistical distribution of instantaneous power, this amplification stage comprising at least one amplifier (32) and adapter circuits (33, 34, 35) determining adjustment parameters whose value influences transfer functions in average power POUT(PIN), in phase PM(PIN), and in consumption PDC(PIN), of the amplification stage, comprising the following steps:

   - for each amplifier (32), selecting a form of ideal variation in average power POUTL (PIN) derivable at any point and which can be provided by an appropriate choice of the adapter circuits (33, 34, 35),
   - for each amplifier (32), calculating, for each value of each adjustment parameter and for each value PIN of average input power, a value of an optimization criterion as a function of the mathematical expectation of at least one optimization parameter linked to the average output power of the amplifier, this mathematical expectation being calculated with said statistical distribution of instantaneous power of the input signal and from at least said ideal variation in average power POUTL (PIN),
   - for each amplifier (32), selecting from each value of the optimization criterion, an optimal value of each adjustment parameter representing an optimization of the optimization criterion of the amplifier (32), and determining a corresponding average output power value of the amplifier,
   - manufacturing the amplification stage with a number N of amplifier(s) (32) in parallel determined as a function of an average output power value to be provided by the amplification stage, and with, for each amplifier (32), adapter circuits (33, 34, 35) providing said optimal values of the adjustment parameters.

2. The method according to claim 1, **characterized in that** the optimization criterion is chosen from the average output power POUTK of the amplifier (32); the consumption PDCk of the amplifier (32); the power dissipated by the amplifier (32); and an efficiency of the amplifier (32) determined by the ratio between the average output power POUTk and the consumption PDCk; and their combinations.

3. The method according to claim 2, **characterized in that** at least one optimization parameter is chosen from the average output power POUTk of the amplifier (32) and the consumption PDCk of the amplifier (32), each value of the optimization criterion being calculated as a function of the mathematical expectation, with the statistical distribution of the input signal, of this optimization parameter from at least said ideal variation in average power POUTL (PIN).

4. The method according to any of claims 1 to 3, **characterized in that** at least one optimization parameter is the consumption PDCk of the amplifier (32), and **in that** it further comprises the following steps:

   - characterizing (11) each amplifier (32), using a test bench measuring and recording, for each value of each adjustment parameter, characteristic variations, as a function of the average input power PIN, the average power POUTcw(PIN) and the consumption PDCcw(PIN) from a constant envelope signal applied to the input of the test bench,
   - for each amplifier (32), calculating, for each value of each adjustment parameter, an ideal variation of the consumption PDCL (PIN) as a function of the average input power PIN, from said ideal variation in average power POUTL (PIN) and said characteristic variations,

   and **in that** each value of the optimization criterion is determined as a function of the mathematical expectation, with the statistical distribution of the input signal, of the consumption PDCL (PIN) obtained from said ideal variation of the consumption PDCL (PIN) as function of the average input power PIN.

5. The method according to claim 4, **characterized in that** it further comprises a step of characterizing each amplifier (32), using a test bench measuring and recording, for each value of each adjustment parameter, characteristic variations, as a function of the average input power PIN, of the phase shift PMcw(PIN) of the amplifier (32) from the constant envelope input signal, and **in that** the adapter circuits (33, 34, 35) are chosen to obtain a phase shift of predetermined value, in particular zero.

6. The method according to any of claims 1 to 5, **characterized in that** said form of ideal variation in average power POUTL (PIN) is an affine variation up to a higher saturation starting value.

7. The method according to any of claims 1 to 6, **characterized in that** the input signal comprises a modulation according to a predetermined modulation scheme.

8. The method according to claim 7, **characterized in that** the varying envelope input signal has an instantaneous power probability density of the input signal determined as a function of the modulation scheme of the communication signal.

9. The method according to any of claims 1 to 8, **characterized in that** said form of ideal variation in average power POUTL (PIN) is chosen as a function of a performance criterion of the amplification stage chosen from a value of a signal/noise ratio and an intermodulation rate.

10. The method according to any of claims 1 to 9, **characterized in that** the input signal is a microwave signal.

11. The method according to any of claims 1 to 10, **characterized in that** at least one amplifier (32) being a transistor, said adjustment parameters are chosen from the group formed by at least one bias voltage and at least one load impedance characteristic.

12. The method according to any of claims 1 to 11, **characterized in that** at least one amplifier (32) being a traveling wave tube, said adjustment parameters are chosen from the group formed by a beam current, a helix voltage, and a collector voltage.

13. The method according to any of claims 1 to 12, **characterized in that** the amplification stage delivering a predetermined average output power POUT, for each amplifier (32), an average output power value POUTk of the amplifier (32) is determined for the optimal values of each adjustment parameter, and **in that** the number N of amplifier(s) in parallel of the amplification stage is chosen such that:

$$\sum_{1}^{N-1} POUTk \leq POUT \leq \sum_{1}^{N} POUTk$$

14. The method according to any of claims 1 to 13, **characterized in that** the amplification stage is manufactured with a plurality of identical amplifiers (32).

15. A power amplification stage of a varying envelope input signal having a predetermined statistical distribution of instantaneous power, this amplification stage comprising a plurality of amplifier (32) and adapter circuits (33, 34, 35) determining adjustment parameters whose value influences transfer functions in average power POUT(PIN), in phase PM(PIN), and in consumption PDC(PIN), of the amplification stage, **characterized in that**:

- it comprises, for each amplifier (32), adapter circuits (33, 34, 35) providing optimal values of the adjustment parameters of the amplifier (32),
- these optimal values being determined from values of an optimization criterion calculated for each value of each adjustment parameter, and so as to represent an optimization of the optimization criterion of the amplifier (32),
- the values of the optimization criterion being calculated as a function of the mathematical expectation of at least one optimization parameter linked to the average output power of the amplifier, this mathematical expectation being calculated with said statistical distribution of instantaneous power of the input signal and at least from an ideal variation in average power $POUT_L(PIN)$ of the amplifier (32),

- it comprises several amplifiers (32) in parallel, the number N of which is determined as a function of an average output power value to be provided by the amplification stage such that:

$$\sum_{1}^{N-1} POUTk \leq POUT \leq \sum_{1}^{N} POUTk$$

with for each amplifier, POUTk an average output power value of the amplifier is determined for the optimal values of each adjustment parameter of the amplifier (32) and POUT a predetermined average output power.

POUTcw
PDCcw — 11

POUT$_L$
PDC$_L$ — 12

13

$E_{POUT_L}[Pi]$
$E_{PDC_L}[Pi]$ — 14

Max[POUTk]
Min[PDCk], $\eta_{max}$ — 15

$\sum_{1}^{N}$POUTk — 16

Fig. 1

EP 3 371 884 B1

Fig. 2

Fig. 3

7 APSK

Fig. 4a

16APSK

Fig. 4b

16 QAM

Fig. 4c

Pi(t)

$$POUT = \sum_1^N POUTk$$

A1

A2

Ak

AN

Fig. 5

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 20120105150 A
- US 20150236729 A

- FR 1453773

**Littérature non-brevet citée dans la description**

- **J. SOMBRIN.** Optimization criteria for power amplifiers. *International Journal of Microwave and Wireless Technologies,* 2011, vol. 3 (1), 35-45
- **M. DE MATOS ; E. KERHERVÉ ; H. LAPUYADE ; J-B. BÉGUERET ; Y. DEVAL.** Caractérisation en puissance aux fréquences millimétriques de circuits nanométriques en technologie silicium. *10èmes journées pédagogiques CNFM (CNFM 2008),* Novembre 2008, 111-116
- **C.W.PARK.** An Independently Controllable AM/AM and AM/PM Predistortion Linearizer for CDMA 2000 Multi-Carrier Applications. *IEEE 2001*

- **O.HAMMI ; S.BOUMAIZA ; F.M.GHANNOUCHI.** On the Robustness of Digital Predistortion Function Synthesis and Average Power Tracking for Highly Nonlinear Power Amplifiers. *IEEE transactions on microwave theory and techniques,* Juin 2007, vol. 55 (6
- **NAGATA Y.** linear amplification technique for digital mobile communications. *39th IEEE vehicular technology conférence,* Mai 1989
- **FAULKNER M ; MATTSON T. ; YATES W.** adaptive linearization using predistortion. *40th of the IEEE vehicular technology conférence,* Mai 1990, 35-40